# EUROPEAN PATENT APPLICATION

(11) **EP 1 855 515 A1**
(43) Date of publication of application: **14.11.2007**
(21) Application number: 06714422.0
(22) Date of filing: 23.02.2006
(51) Int. Cl.: H05K 3/28, H05K 1/11, H05K 3/18

(54) **PRINTED BOARD AND METHOD FOR MANUFACTURING SAME**

(30) Priority: 28.02.2005 JP 2005053199
(71) Applicant: So-Ken Co., Ltd, Kamiina-gun, Nagano, 3994585 (JP)
(72) Inventor: KAWAKAMI, Takashi, amiina-gun, Nagano, 3994585 (JP); SASO, Nobuyuki, amiina-gun, Nagano, 3994585 (JP)
(74) Representative: Albutt, Anthony John
(86) International application number: PCT/JP2006/303282
(87) International publication number: WO 2006/093016

(57) **Abstract**

This invention relates to a printed circuit board which comprises a porous sheet or foil composed of a non-conductive material; a circuit pattern composed of a conductive material formed on the porous sheet or foil; and an organic polymer coating as an insulating layer formed by vapor deposition polymerization.

Also this invention relates to a method for manufacturing a printed circuit board comprising a step of forming a photo-resist layer on a non-conductive porous sheet or foil; a step of forming a circuit pattern in the photo-resist layer by exposing and developing; a step of plating the circuit pattern with a conductive material; a step of removing the photo-resist layer; and a step of forming an organic polymer coating over the circuit pattern of the conductive material by means of vapor deposition polymerization.

## Description

### [Technical Field]

The present invention is related to a printed circuit board and a method for manufacturing the same, such as a flat cable, a planar antenna, a semiconductor device, a semiconductor socket utilized in the technical fields of information appliances, electronic devices, portable devices, motor components, aerospace apparatus and so forth.

### [Background of the Technique]

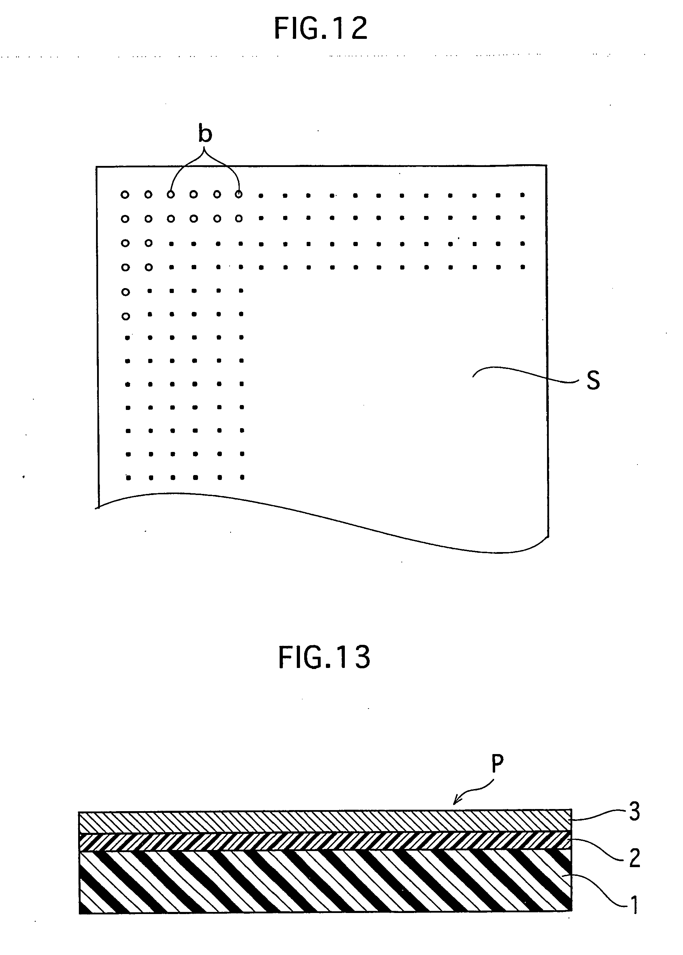

Conventionally, a printed circuit board P is manufactured by bonding a thin copper foil 3 on the surface of a resin substrate 1 with adhesive 2 as shown in FIG.13. Subsequently, a circuit pattern is formed by spreading photo-resistive emulsion on the copper foil 3, exposing and developing the emulsion, and then etching the copper foil 3.

However, the copper foil 3 is easy to peel off when the printed circuit board P is bent. There is a method that makes the adhesive 2 strong to prevent the copper foil 3 from peeling off. But the adhesive 2 becomes easy to crack and conductivity tends to be lost when the printed circuit board P is bent. Moreover, the process of operation which forms through-holes with a drill needs a considerable time.

To avoid the above-mentioned disadvantage, as disclosed in Patent Document 1, there is a method that forms a circuit pattern using a porous sheet as the resin substrate 1. However, the method has other disadvantages.

It is necessary to form an insulating layer on the circuit pattern for the printed circuit board that has the circuit pattern formed on the porous sheet or foil with a conductive material. However, flexibility of the printed circuit board is few when a hard resin such as epoxy is used to form the insulating layer and thereby the insulating layer becomes easy to crack when the printed circuit board is bent. Moreover, there is a method that bonds a polyester film or a polyimide film as the insulating layer to the printed circuit board. However, there is a disadvantage that cannot use the flexibility of the porous sheet.

Patent Document 1: JP2,799,411

### [Disclosure of Invention]

### [Problem to be solved by the Invention]

This invention has been made in consideration of the above disadvantage. It is an object of this invention to provide the printed circuit board and the method for manufacturing same which can solve the conventional disadvantage.

### [Means to solve the problem]

A printed circuit board of this invention comprises: a porous sheet or foil composed of a non-conductive material; a circuit pattern composed of a conductive material formed on the porous sheet or foil; and an organic polymer coating as an insulating layer formed by vapor deposition polymerization.

Further a printed circuit board of this invention comprises: a first circuit board having a first circuit pattern formed on a first porous sheet or foil composed of a non-conductive material; and a second circuit board having a second circuit pattern formed on a second porous sheet or foil composed of a non-conductive material; wherein the first and second circuit boards are integrated with in piles so as to contact the part or whole of the first circuit pattern with the part or whole of the second circuit pattern, and an organic polymer coating as an insulating layer is formed over the first and second circuit patterns.

Further, a method for manufacturing a printed circuit board of this invention comprises the steps of:
(A) forming a photo-resist layer on a non-conductive porous sheet or foil;
(B) forming a circuit pattern in the photo-resist layer by exposing and developing;
(C) electrolytically plating the circuit pattern with a conductive material;
(D) removing the photo-resist layer; and
(E) forming an organic polymer coating over the circuit pattern of the conductive material by means of vapor deposition polymerization.

Further, a method for manufacturing a printed circuit board of this invention comprises the steps of:
(A) forming a photo-resist layer on a non-conductive porous sheet or foil;
(B) forming a circuit pattern in the photo-resist layer by exposing and developing;
(C) electrolytically plating the circuit pattern with a conductive material;
(D) removing the photo-resist layer;
(E) thickening the circuit pattern by plating the circuit pattern with the same conductive material; and
(F) forming an organic polymer coating over the circuit pattern of the conductive material by means of vapor deposition polymerization.

### [Effect of the Invention]

According to the printed circuit board and a method for manufacturing the same of this invention, the entire thickness including an insulating layer becomes very small, flexibility can be improved, bending operation can be easily in the narrow space in a equipment, and the overall circuit configuration can be made easy and compact.

### [Brief Description of the Drawings]

FIG. 1 is a partial perspective view of a net as a sheet applied to a first embodiment of this invention.
FIG.2 is a sectional view which shows a first process of manufacturing process of a printed circuit board according to the first embodiment.
FIG.3 is a sectional view which shows a second process of manufacturing process of a printed circuit board by the first embodiment.
FIG.4 is a sectional view which shows a third process of manufacturing process of a printed circuit board by the first embodiment.
FIG.5 is a sectional view which shows a fourth process of manufacturing process of a printed circuit board by the first embodiment.
FIG.6 is a plane view which shows an example of circuit pattern.
FIG. 7 is a section view of a printed circuit board according to the first embodiment. Conventional insulating layer 2 is shown in dotted line, for comparison.
FIG. 8 is a sectional view of a printed circuit board according to a second embodiment of this invention.
FIG. 9 is a sectional view which shows an example of modification of a printed circuit board according to the first embodiment.
FIG. 10 is a sectional view which shows an example of modification of a printed circuit board according to the second embodiment.
FIG. 11 is a schematic view of a vapor deposition polymerization apparatus applied to the first and second embodiment of this invention.
FIG.12 is a part plane view which shows an example of modification of a sheet pertaining to this invention.
FIG. 13 is a section view of a conventional printed circuit board.

### [Explanations of letters or numerals]

- 10: net
- 14: photo-resist
- 18: copper
- m: polyimide
- 60: vapor deposition polymerization apparatus

### [Best Mode for Carrying out the Invention]

Next, embodiments of this invention will be described with reference to the drawings.

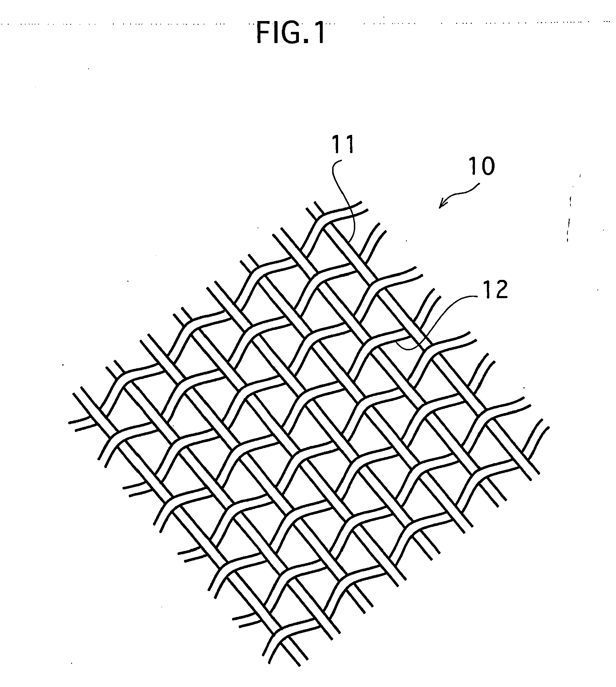

FIG.1 shows a net 10 as a porous sheet composed of a non-conductive material and applied to a first and second embodiments of this invention. Net 10 consists of woof 11 and warp 12, which are composed of liquid crystal polymer.

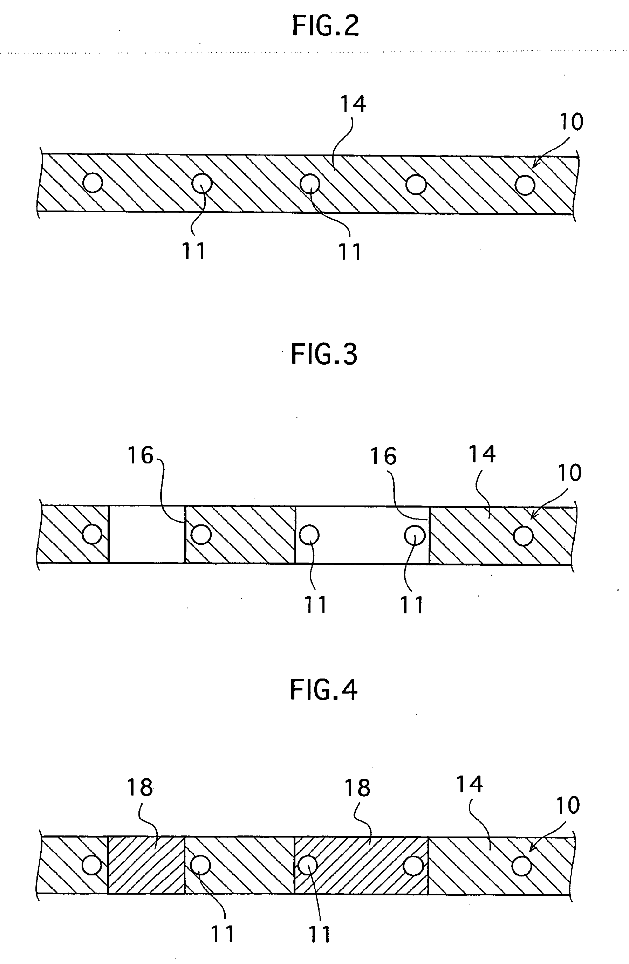

As shown in FIG.2, sensitizer or photo-resist 14 is applied to the net 10. Subsequently, the photo-resist is exposed with a photo-mask (not shown) having a predetermined pattern and developed and thereby a predetermined aperture pattern 16 is formed in the photo-resist 14 (FIG.3).

Next, as shown in FIG.4, non-electrolytic plating of the copper (Cu) 18 as a conductive material is carried out to the aperture pattern 16.

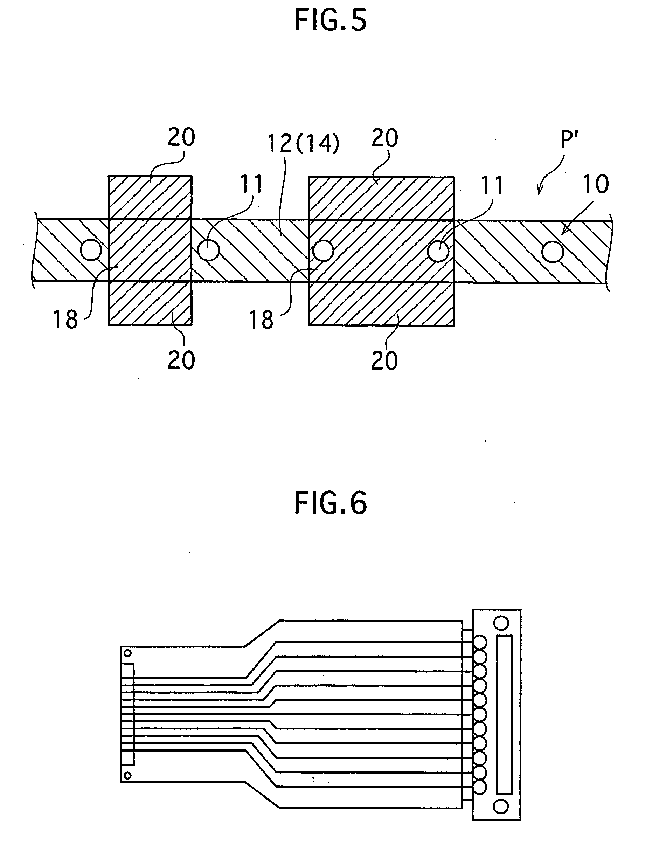

And then, it is dipped into a solution including the Cu ion and an electric current is applied. Therefore, as shown in Fig.5 copper 20 is grown up on the above-mentioned plating 18 (electrolytic plating) and a circuit pattern composed of conductive material is formed. Desired thickness of the circuit pattern can be obtained by adjusting the time for plating. FIG.6 shows one of example of the circuit pattern.

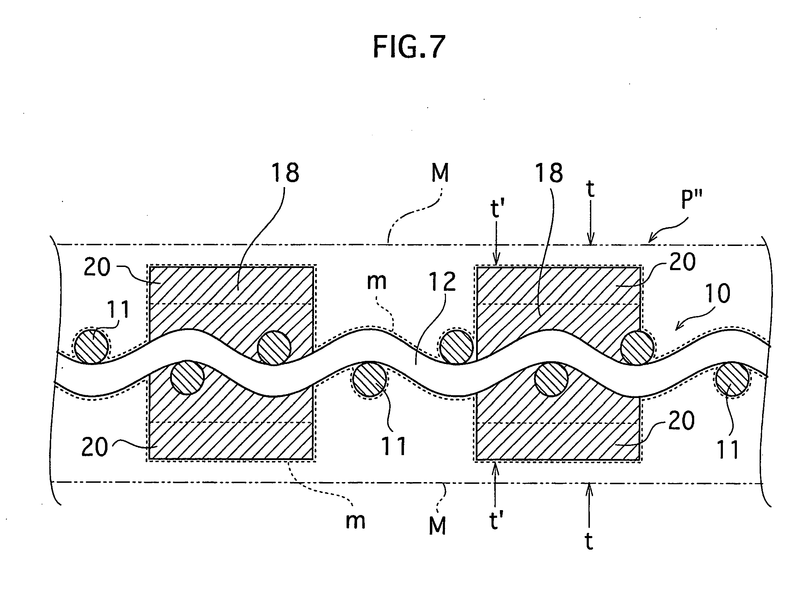

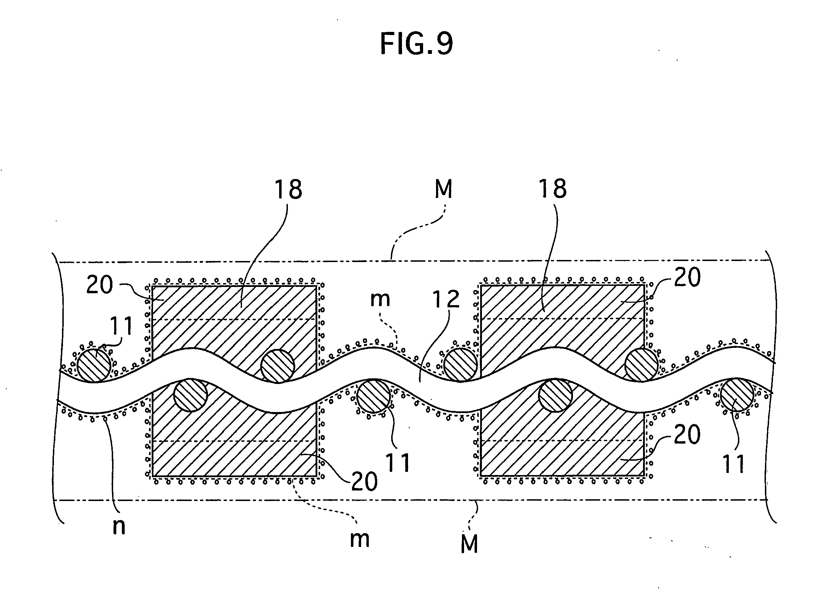

Afterwards, the photo-resist 14 is removed with appropriate solvents. Therefore, the circuit pattern of copper formed on the net 10 is obtained. After removing the photo-resist 14, the parts of the net 10 except for the plated portion are exposed. However, the net 10 is shown in FIG.5 assuming that keeps the same shape as a sheet 10 in order to facilitate the understanding of figure. Actually, the circuit pattern is shown as FIG.7 and FIG.9.

Next, a vapor deposition polymerization apparatus 60 applied to the present invention will be described.

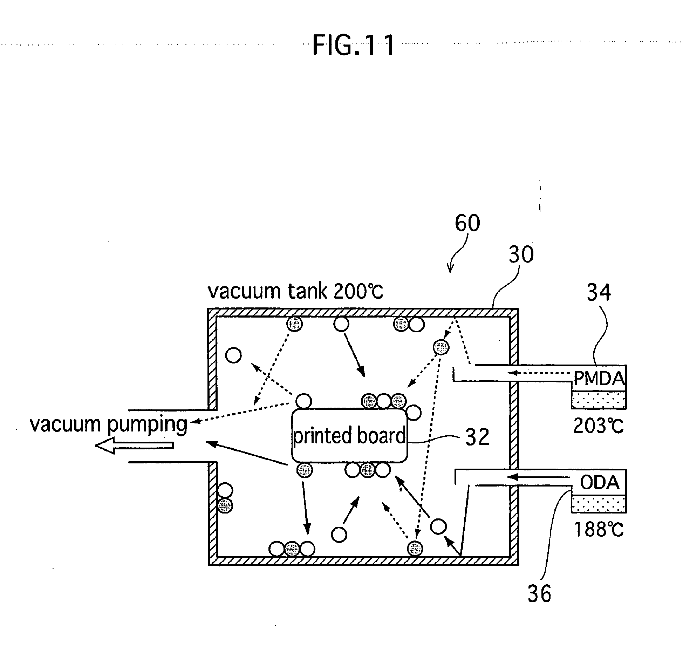

Usually, vapor deposition polymerization method can form a polymer film only to the substrate surface facing to evaporation sources. In this embodiment, as shown in FIG.11, a substrate 32 and a vacuum tank 30 are heated to evaporation temperature level (for example 200°C) of monomer and two kinds of monomers are introduced into the vacuum tank 30. The temperatures of the substrate 32 and the vacuum tank 30 and introduction pressures of monomers are controlled so as to be identical with the saturated vapor pressures of monomers, thereby polyimide film can be formed on the all surface of the substrate 32 having a complicated shape (all directions simultaneous deposition polymerization).

In this embodiment as shown in FIG.11, PMDA (Pyromellitic dianhydride) 34 and ODA (Oxydianiline) 36 as monomers are supplied into the vacuum tank 30.

When only one kind of monomer is supplied, monomer cannot adhere onto the substrate 32 and the vacuum tank 30 and is pumped out. On the other hand, when two kinds of monomers are simultaneously supplied, both react on the substrate 32, and become a dimer or a trimer, and adhere on the substrate 32, and then grow up to be high polymeric substances. Because the unreacting monomer molecules evaporate again from the wall surface of vacuum tank, the thin polymer film is obtained with a uniform thickness distribution. Thus, substrates and parts having complicated shapes can be covered in uniformity with the polyimide film.

The vapor deposition polymerization method has feature that purity of formed film is high and feature that solvent treatments for adding, removing and collecting are nothing (pollution-free). Therefore, the film which is high purity is obtained. Moreover, the film can be formed so as to follow the shape of substrate surface and therefore the film can be formed onto internal surfaces of fine pores.

In FIG.11, the substrate 32 corresponds to a printed circuit board P' shown in FIG.5. The printed circuit board P' comprises the net 10, the circuit patterns 18, 20. In this embodiment, the polyimide film can be simultaneously formed on the front and back surfaces of the printed circuit board P' and the film forming process can be carried out in a short time.

FIG.7 shows a printed circuit board P" covered with polyimide coating (organic polymer coating) m as insulating layers which is formed by the above described deposition polymerization process. Conventionally, for example epoxy material M was formed as the insulating layer as shown in two dotted line. In this case, thickness t of the conventional board was about 40 micrometers. But thickness t' of the printed circuit board P" pertaining to this invention is about 1 micrometer including circuit patterns (18, 20). In FIG.7, the thickness of epoxy material M is reduces greatly to make figure plain. Moreover, disregard the overall ratio in figure.

The part where the meshes of net 10 is open considerably remains in plane view. The printed circuit board P" obtained by the above-mentioned method has high flexibility and high heatproof.

In addition, metal layers (for example aluminum layers) n may be formed by sputter on the polyimide coating m as shown in FIG.9. As a result, electromagnetic shield effects from the outside to the inside (EMS) and from the inside to the outside (EMI) can be obtained.

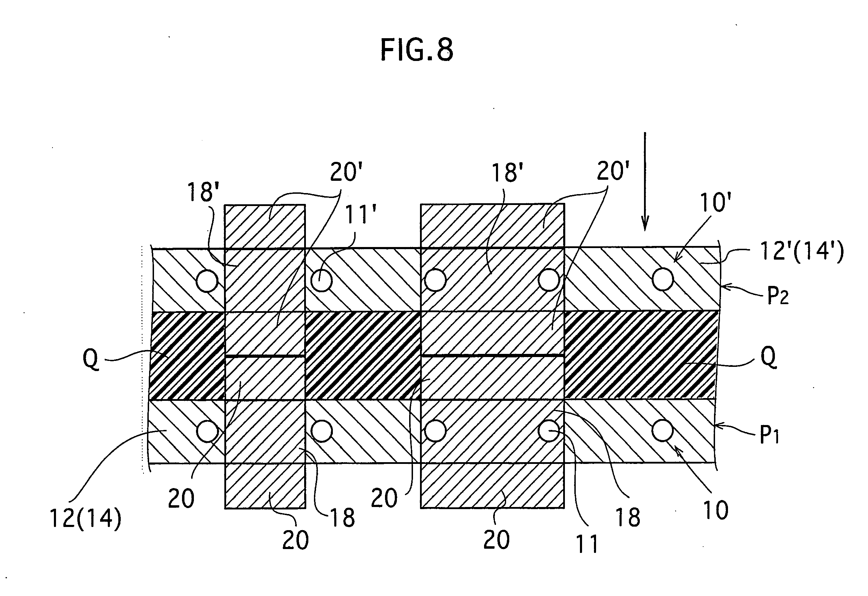

FIG. 8 shows a second embodiment according to this invention. A printed circuit board pertaining to this embodiment is configured by plural (for example two pieces) printed circuit boards, which are manufactured in the first embodiment, integrated with in piles. The circuit pattern of the upward printed circuit board P2 may be same as that of the downward printed circuit board P1 and may be different. FIG. 8 shows the case that each circuit pattern is same, respectively. The arrow indicates the direction of the suppress strength. Pattern portions 20 arid 20' contacting each other are welded by pressure.

The printed circuit board P1 and the printed circuit board P2 are mutually integrated with an adhesive layer Q. The circuit pattern of the printed circuit board P1 and the circuit pattern of the printed circuit board P2 are mutually conductive through the parts where the pattern portions 20 and 20' contact.

Polyimide coating is formed on the all surfaces of unified printed circuit boards P1 and P2 by the deposition polymerization apparatus shown in FIG.11. Monomers reach spaces between the printed circuit boards P1 and P2, and between the adhesive layer Q and circuit patterns, and fine pores, and then form polyimide coating.

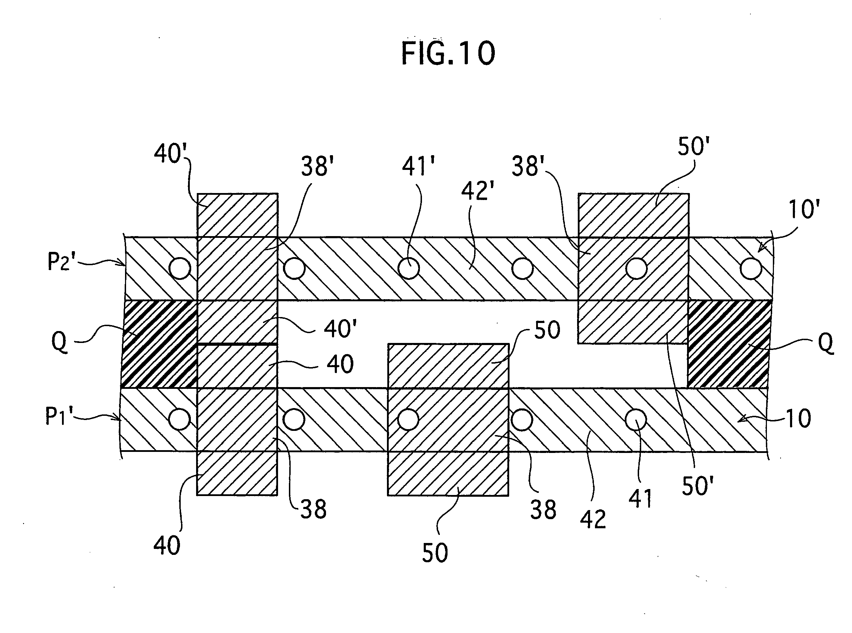

FIG. 10 is a sectional view which shows an example of modification of a printed circuit board according to the second embodiment. Circuit patterns (38, 40, 50) formed on a first printed circuit board P1' is different from circuit patterns (38', 40', 50') formed on a second printed circuit board P2'.

These circuit patterns are formed as well as the circuit pattern in the first embodiment. As shown in FIG 10, when the printed circuit board P1' and P2' are integrated with in piles, there are the areas (50, 50') where the upward and downward circuit patterns do not contact. The printed circuit boards P1' and P2' are integrated with the adhesive layers Q applied as shown in figure.

In this embodiment, the polyimide coating is formed on the all surface of the integrated printed circuit boards P1' and P2' by using the deposition polymerization apparatus shown in FIG.11. The polyimide coating can be formed, not only on the circuit patterns at the sides of the upward surface of the printed circuit board P1' and the downward surface of the printed circuit board P2', but also on the all surfaces of the nets 10 and 10'.

In addition, although the adhesive layers Q touch pattern portions (40, 40', 50') in FIG.10, spaces may be formed among these. In this case, the polyimide coating is formed in these spaces.

While the preferred embodiments of this invention have been described, without being limited to this, variations thereto will occur to those skilled in the art within the scope of the present invention concepts.

For example, in the above described embodiments copper is used as a conductive material forming circuit patterns. But other conductive materials such as aluminum (Al) and gold (Au) can be used as the conductive materials.

Also, nickel (Ni) and/or gold (Au) may be plated on the surface of copper as circuit patterns in order to prevent oxidation of the copper. In this case it shall be included in the circuit pattern of the present invention.

Further, in the above embodiments the net 10 is composed of liquid crystalline polymer. But it may be composed of other non-conductive material such as polyester.

Further, in the above embodiments polyimide coating is formed as an organic polymer coating obtained by deposition polymerization. But the organic polymer coating may be composed of other materials formed by deposition polymerization, such as polyurea and polyamide. When the kinds of the monomers are changed, the vapor deposition polymer of various organic macromolecules is provided. It can be used depending on the characteristic.

In addition, in the above embodiments the net 10 consisting of the woof and the warp composed of the liquid crystalline polymer is used as a seat pertaining to this invention. Instead, as shown in FIG.12 it may use a foil S of a non-conductive material in which many penetration holes are formed.

## Claims

1. A printed circuit board comprising:
a porous sheet or foil composed of a non-conductive material;
a circuit pattern composed of a conductive material formed on said porous sheet or foil; and
an organic polymer coating as an insulating layer formed by vapor deposition polymerization.

2. A printed circuit board according to claim 1 in which said organic polymer coating is made of polyimide, or polyamide, or polyurea.

3. A printed circuit board according to claim 1 in which a metal layer is formed on said organic polymer coating.

4. A printed circuit board comprising:
a first circuit board having a first circuit pattern formed on a first porous sheet or foil composed of a non-conductive material; and
a second circuit board having a second circuit pattern formed on a second porous sheet or foil composed of a non-conductive material;
wherein said first and second circuit boards are integrated with in piles so as to contact the part or whole of said first circuit pattern with the part or whole of said second circuit pattern, and
an organic polymer coating as an insulating layer is formed over said first and second circuit patterns.

5. A printed circuit board according to claim 4 in which three or more circuit boards are integrated with in piles.

6. A printed circuit board according to claim 4 in which said organic polymer coating is made of polyimide, or polyamide, or polyurea.

7. A printed circuit board according to claim 4 in which a metal layer is formed on said organic polymer coating.

8. A method for manufacturing a printed circuit board, comprising the steps of:
(A) forming a photo-resist layer on a non-conductive porous sheet or foil;
(B) forming a circuit pattern in said photo-resist layer by exposing and developing;
(C) electrolytically plating said circuit pattern with a conductive material;
(D) removing said photo-resist layer; and
(E) forming an organic polymer coating over said circuit pattern of said conductive material by means of vapor deposition polymerization.

9. A method for manufacturing a printed circuit board, comprising the steps of:
(A) forming a photo-resist layer on a non-conductive porous sheet or foil
(B) forming a circuit pattern in said photo-resist layer by exposing and developing;
(C) electrolytically plating said circuit pattern with a conductive material;
(D) removing said photo-resist layer;
(E) thickening said circuit pattern by plating said circuit pattern with the same conductive material; and
(F) forming an organic polymer coating over said circuit pattern of said conductive material by means of vapor deposition polymerization.

10. A method for manufacturing a printed circuit board according to claim 8 further comprising the step of:
forming a metal layer on said circuit pattern made of said conductive material.

11. A method for manufacturing a printed circuit board according to claim 8 in which said organic polymer coating is made of polyimide, or polyamide, or polyurea.
